# EUROPEAN PATENT APPLICATION

(11) **EP 3 578 997 A1**
(43) Date of publication of application: **11.12.2019**
(21) Application number: 19178072.5
(22) Date of filing: 04.06.2019
(51) Int. Cl.: G01R 1/20, G01R 31/364, H01R 11/28

(54) **CURRENT SENSOR**

(30) Priority: 05.06.2018 JP 2018107677; 14.12.2018 JP 2018234323
(71) Applicant: YAZAKI CORPORATION, Minato-ku, Tokyo 108-8333 (JP)
(72) Inventor: KAWAGUCHI, Yasunori, Makinohara-shi, Shizuoka 421-0407 (JP); TOMA, Takanori, Makinohara-shi, Shizuoka 421-0407 (JP)
(74) Representative: Grünecker Patent- und Rechtsanwälte PartG mbB

(57) **Abstract**

A current sensor includes a housing with a bus bar. The housing with a bus bar includes a housing formed of an insulating resin material and a first bus bar and a second bus bar that are inserted into the housing. A recess portion is formed in the housing. A first exposed portion of the first bus bar and a second exposed portion of the second bus bar are exposed in the recess portion. A shunt resistor electrically connects the first exposed portion and the second exposed portion to each other in a state where the shunt resistor is accommodated in the recess portion.

## Description

### BACKGROUND

### 1. TECHNICAL FIELD

The present invention relates to a current sensor.

### 2. RELATED ART

In recent years, a type and the number of electrical components of an automobile have rapidly increased, and consumption of an in-vehicle battery has become gradually severe. For this reason, it has been suggested to mount a current sensor on a battery post formed in a battery. By mounting the current sensor on the battery post, generally, the remaining amount of battery is monitored and an alternator (generator) is controlled, such that improvement of fuel efficiency is promoted or a consumption degree (deterioration) of the battery is checked on the basis of the output of the current sensor. As described above, in recent years where the consumption of the in-vehicle battery has become gradually severe, there is a demand for monitoring the remaining capacity of the battery for charge and discharge control. In order to meet such a demand, a method of mounting the current sensor on the battery post and detecting a consumption degree of the battery by a magnitude of a current detected by the current sensor has been suggested.

In addition, as this type of current sensor, a so-called shunt-type current sensor that calculates a current value using Ohm's law (current = voltage drop/resistance value) from a voltage drop at the time of allowing a current to flow a shunt resistor to conduct electricity and a resistance value of the shunt resistor, has been generally known.

As such a shunt-type current sensor, a current sensor disclosed in Patent Literature 1 (Japanese Patent Application Laid-Open Publication No. 2008-514941 has been known. Patent Literature 1 discloses a current sensor including a bus bar (connection region) connected to a pole of an electrical current supply device, a bus bar (connection region) connected to an electrical consumer, and a shunt resistor (measurement segment) electrically connecting the two bus bars to each other.

In Patent Literature 1, the bus bars with the shunt resistor are formed by welding each joint place between each bus bar and the shunt resistor, and the bus bars with the shunt resistor are insert-molded in a housing. In this case, the bus bars with the shunt resistor are insert-molded in the housing so that the shunt resistor and bounded portions between the shunt resistor and each bus bar in each bus bar are embedded in the housing.

### SUMMARY

However, in the related art, after the bus bars with the shunt resistor are formed, the bus bars with the shunt resistor are insert-molded in the housing. By insert-molding the bus bars with the shunt resistor in the housing, the shunt resistor and the bounded portions between the shunt resistor and each bus bar in each bus bar are embedded in the housing.

For this reason, the bus bars with the shunt resistor may be deformed due to a pressure of a resin material applied to the bus bars with the shunt resistor at the time of insert-molding the bus bars with the shunt resistor in the housing, a force applied to the bus bars with the shunt resistor due to thermal expansion and contraction, vibration, etc., of the current sensor, or the like. In a case where the bus bars with the shunt resistor are deformed as described above, there is a risk that current detection may not be correctly performed because the shunt resistor and the bus bars are not electrically connected to each other.

In addition, in the related art, friction may occur between the bus bars with the shunt resistor and the housing at the time of the thermal expansion and contraction of the current sensor or at the time of the vibration of the current sensor, and static electricity may be generated due to this friction. When the static electricity is generated due to the friction occurring between the bus bars with the shunt resistor and the housing, there is a risk that this static electricity will become noise to have an influence on the current detection by the current sensor.

As described above, in the related art, it is difficult to improve reliability of the current detection by the current sensor.

An object of the present invention is to provide a current sensor capable of further improving reliability of current detection.

According to the present invention, there is provided a current sensor including: a housing with a bus bar that includes a housing formed of an insulating resin material, a first bus bar inserted into the housing so as to be partially embedded in the housing and mounted on a battery post, and a second bus bar inserted into the housing so as to be partially embedded in the housing in a state where the second bus bar is spaced apart from the first bus bar and connected to a wire harness; and a shunt resistor that electrically connects the first bus bar and the second bus bar to each other, wherein a recess portion in which a first exposed portion of the first bus bar is exposed and a second exposed portion of the second bus bar is exposed, is formed in the housing, and the shunt resistor electrically connects the first exposed portion and the second exposed portion to each other in a state where the shunt resistor is accommodated in the recess portion.

The current sensor may further include a circuit board to which a potential difference across the shunt resistor is input, wherein the circuit board is arranged in the recess portion.

The current sensor may further include a pair of output terminals that are connected to the circuit board and output the potential difference across the shunt resistor to the circuit board, wherein one output terminal of the pair of output terminals is formed integrally with the first bus bar, and the other output terminal of the pair of output terminals is formed integrally with the second bus bar.

A sealing portion sealed by a sealing material softer than the resin material may be provided in the recess portion.

A rugged portion may be formed on a surface portion corresponding to the recess portion in a surface exposed to the outside of the housing, and the rugged portion may be configured by arranging a plurality of grooves at predetermined intervals in a direction orthogonal to an interval direction between the first exposed portion and the second exposed portion in the recess portion, the grooves extending in the interval direction.

The shunt resistor may be formed to have a larger dimension in the interval direction than in a direction orthogonal to the interval direction.

According to the present invention, it is possible to provide a current sensor capable of further improving reliability of current detection.

### BRIEF DESCRIPTION OF DRAWINGS

FIG. 1 is a perspective view schematically illustrating a battery on which a current sensor according to an embodiment is mounted;
FIG. 2 is a perspective view schematically illustrating a state where the current sensor according to the embodiment is mounted on a battery post;
FIG. 3 is a perspective view schematically illustrating the current sensor according to the embodiment;
FIG. 4 is an exploded perspective view schematically illustrating the current sensor according to the embodiment;
FIG. 5 is a view illustrating an example of a method of manufacturing the current sensor according to the embodiment, and a perspective view schematically illustrating a state where an insert component is arranged at a predetermined position;
FIG. 6 is a view illustrating an example of a method of manufacturing the current sensor according to the embodiment, and a view schematically illustrating a state where a housing with a bus bar is formed;
FIG. 7 is a view illustrating an example of a method of manufacturing the current sensor according to the embodiment, and a view schematically illustrating a state where a shunt resistor is arranged in the housing with the bus bar;
FIG. 8 is a perspective view for describing a state where a first bus bar and a second bus bar are electrically connected to each other by the shunt resistor;
FIG. 9 is a perspective view schematically illustrating a state where a circuit board is arranged in a recess portion of the current sensor according to the embodiment;
FIG. 10 is a cross-sectional view schematically illustrating a state where a sealing portion is provided in the recess portion of the current sensor according to the embodiment;
FIG. 11 is a perspective view illustrating a rugged portion formed in a heat radiating portion of the housing exposed on a surface of a sensor main body portion of FIG. 2;
FIG. 12 is a cross-sectional view taken along line I-I of FIG. 11;
FIG. 13A is a distribution diagram illustrating a distribution of stresses caused by a temperature change in the shunt resistor connecting the first bus bar and the second bus bar exposed in the recess portion of the housing to each other in a case where a flow direction of a resin material of a portion forming the recess portion of the housing is aligned with an interval direction between the first bus bar and the second bus bar; and
FIG. 13B is a distribution diagram illustrating a distribution of stresses caused by a temperature change in the shunt resistor connecting the first bus bar and the second bus bar exposed in the recess portion of the housing to each other in a case where a flow direction of a resin material of a portion forming the recess portion of the housing is a direction orthogonal to the interval direction between the first bus bar and the second bus bar.

### DETAILED DESCRIPTION

Hereinafter, embodiments of the present invention will be described in detail with reference to the drawings. It is noted that a current sensor also having a function as a battery terminal mounted in a battery is hereinafter exemplified.

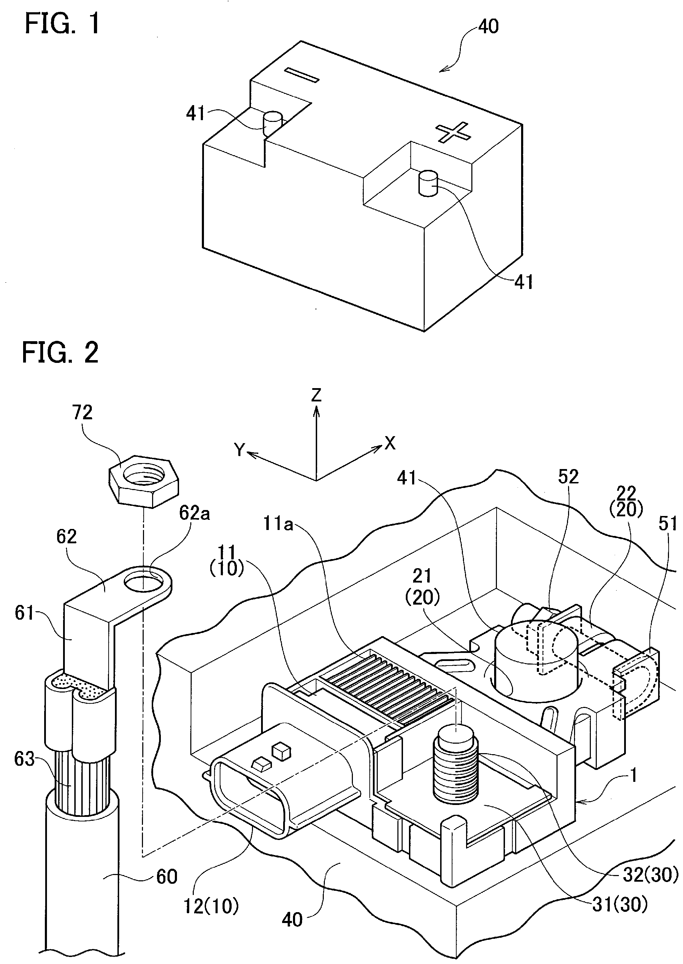

A current sensor 1 according to the present embodiment is mounted on a battery 40 as illustrated in FIG. 1. The current sensor 1 detects a charge/discharge current of the battery 40 and detects the remaining capacity or a consumption degree of the battery 40 depending on a magnitude of the detected charge/discharge current.

An example of the battery 40 can include an in-vehicle battery arranged in an engine room of a vehicle and supplying power to electrical components (vehicle mounted components) mounted in the vehicle.

In the present embodiment, the battery 40 has a shape in which a part of a rectangular parallelepiped is cut out, as illustrated in FIG. 1. Specifically, two corner portions adjacent to each other in an upper portion of the rectangular parallelepiped are formed in a step shape to be on a level lower than the other portions by one step. A pair of battery posts 41 formed of a lead electrode and having a substantially rod shape protrude upward from a surface (terminal mounted surface) on a level lower than an upper surface of the battery 40 by one step. The battery post 41 protruding on one side (right side in FIG. 1) of the terminal mounted surface is a battery post on a positive electrode side, and the battery post 41 protruding on the other side (left side in FIG. 1) of the terminal mounted surface is a battery post on a negative electrode side.

As described above, in the present embodiment, the battery 40 in which wall surfaces are formed beside the pair of battery posts 41 (the battery post 41 on the positive electrode side and the battery post 41 on the negative electrode side) is exemplified. However, the shape of the battery is not limited to the shape described above. For example, the pair of battery posts may protrude from the upper surface of the battery having a substantially rectangular parallelepiped shape.

The current sensor 1 is mounted on each battery post 41.

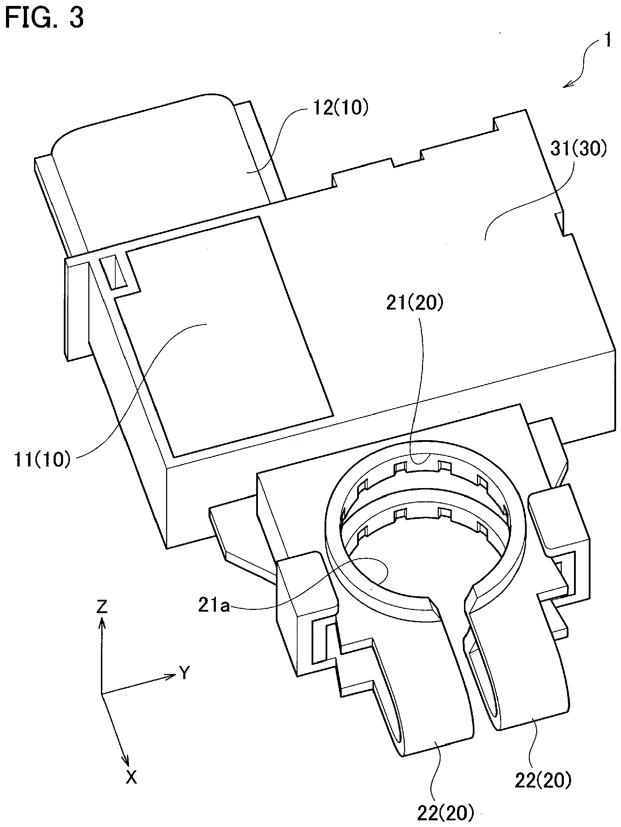

The current sensor 1 includes a sensor portion 10 that detects the charge/discharge current of the battery 40, a battery terminal portion 20 mounted on the battery post 41, and a connection portion 30 that makes a connection to a wire harness 60, as illustrated in FIGS. 2 and 3.

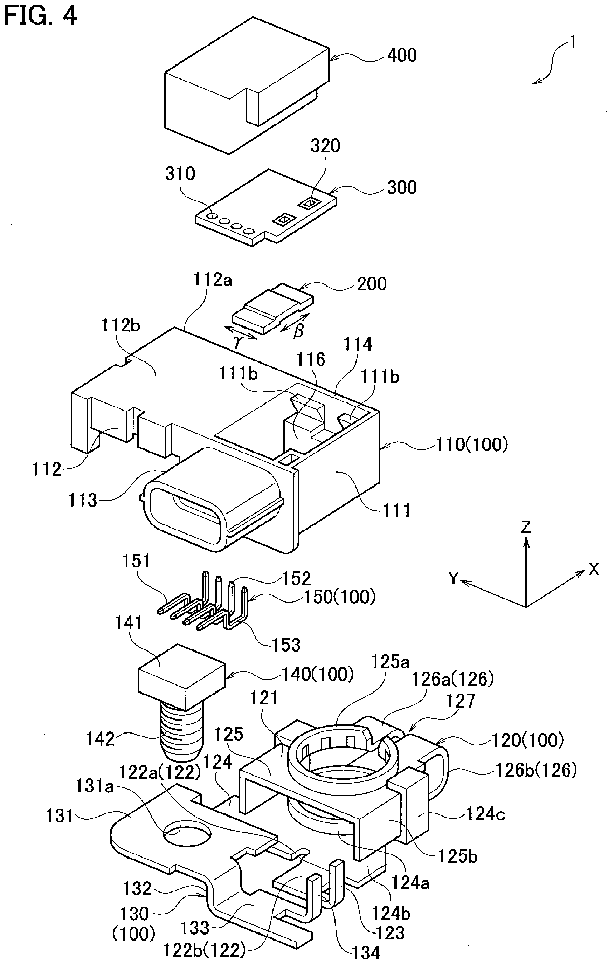

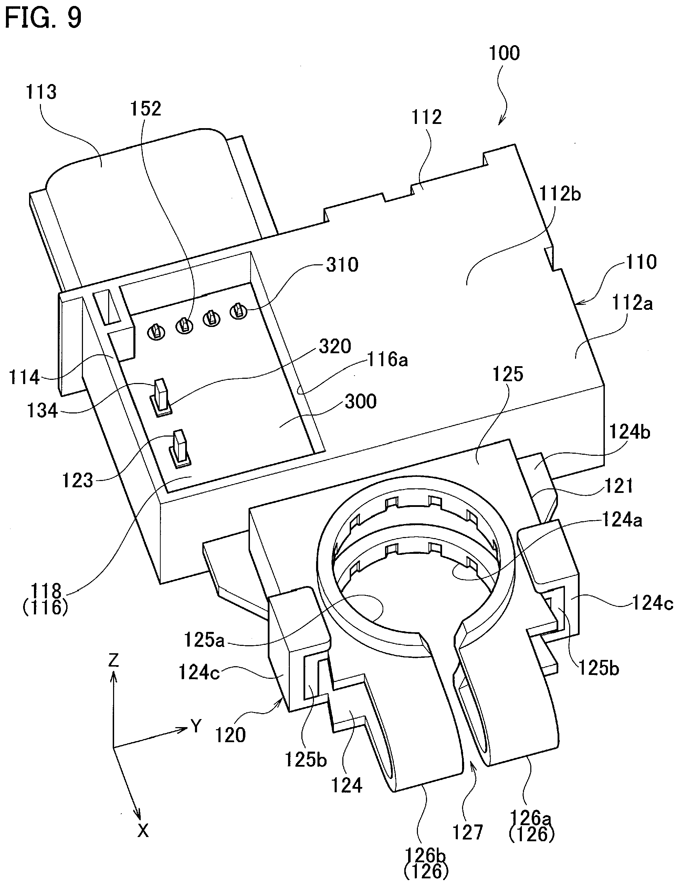

It is noted that FIG. 3 is a view in which the current sensor 1 illustrated in FIG. 2 is turned over (that is, a view in which an upper side and a lower side are inverted). That is, an upper side of the current sensor 1 illustrated in FIG. 2 corresponds to a lower side of the current sensor 1 illustrated in FIG. 3. In addition, FIGS. 4 to 10 are views corresponding to FIG. 3. That is, an upper side of the current sensor 1 illustrated in FIG. 2 corresponds to a lower side of the current sensor illustrated in FIGS. 4 to 10.

The sensor portion 10 illustrated in FIG. 2 includes a sensor main body portion 11 that detects the charge/discharge current of the battery 40 and a connector portion 12 integrally protruding on a side of the sensor main body portion 11 and fitted to a mating connector.

In the following description, as illustrated in FIG. 2, a direction in which the mating connector (not illustrated) is fitted to the connector portion 12 is referred to as a longitudinal direction X of the current sensor 1. A direction orthogonal to the longitudinal direction X is referred to as a width direction Y of the current sensor 1. An erection direction of the battery post 41 mounted on the battery terminal portion 20 is referred to as a height direction Z of the current sensor 1.

The sensor main body portion 11 includes a case constituting an outer shell and a current sensor portion embedded in the case.

Specifically, the sensor main body portion 11 includes an extending piece 122 and an output terminal 123 of a first bus bar 120, and an extending piece 133 and an output terminal 134 of a second bus bar 130, as illustrated in FIG. 4. In addition, the sensor main body portion 11 includes a main body housing 111 holding a part of the first bus bar 120 and a part of the second bus bar 130, and a shunt resistor 200 electrically connecting the first bus bar 120 and the second bus bar 130 to each other. Further, the sensor main body portion 11 includes a circuit board 300 to which a potential difference across the shunt resistor 200 is input, and a sealing portion 400 sealing the shunt resistor 200 and the circuit board 300. It is noted that details of each member constituting the sensor main body portion 11 will be described below.

In the sensor main body portion 11, the shunt resistor 200 electrically connecting the first bus bar 120 and the second bus bar 130 to each other functions as a current sensor portion. That is, in the present embodiment, the sensor main body portion 11 is formed by embedding the shunt resistor 200 functioning as the current sensor portion in a case constituted by the main body housing 111 and the sealing portion 400

In addition, as illustrated in FIG. 2, it is preferable to provide a heat radiating portion 11a on a surface of the sensor main body portion 11. The heat radiating portion 11a is formed using a material having a relatively high thermal conductivity, such as a metal. As an example, a metal plate molded in a corrugated shape is arranged to be exposed on the surface of the sensor main body portion 11. It is noted that the metal plate can be arranged on the surface of the sensor main body portion 11 by various methods such as fitting by press fitting or integral molding by insert molding. The sensor main body portion 11 may have a function as the heat radiating portion 11a by making a shape of the main body housing 111 itself a corrugated shape.

By providing the heat radiating portion 11a, a surface area of the sensor main body portion 11 can be increased, and heat generated in the sensor main body portion 11 can be more efficiently radiated (discharged) to the outside. That is, by providing the heat radiating portion 11a, a heat radiating property (heat discharging property) of the sensor main body portion 11 can be further improved.

The connector portion 12 is formed in a cylindrical shape that is opened to one side, and a terminal metal fitting is incorporated in the connector portion 12. In the present embodiment, the connector portion 12 includes a connector terminal portion 151 of a connector pin 150, and a connector housing 113 formed to cover the connector terminal portion 151 and having a substantially cylindrical shape.

The battery terminal portion 20 is formed in the first bus bar 120, and is formed, for example, by bending or pressing the first bus bar 120. In the present embodiment, a battery terminal main body 121 of the first bus bar 120 is the battery terminal portion 20.

The battery terminal portion 20 includes an insertion portion 21 in which an insertion hole 21a into which the battery post 41 is inserted is formed, and tightened portions 22 provided continuously to the insertion portion 21 and tightened by a bolt 51 and a nut 52 for fixing illustrated in FIG. 2, as illustrated in FIG. 3.

In the present embodiment, an inner diameter of the insertion hole 21a can be changed depending on a tightened state of the tightened portions 22 of FIG. 3 by the bolt 51 and the nut 52 illustrated in FIG. 2.

The battery terminal portion 20 is mounted on the battery post 41 according to, for example, the following procedure. First, as illustrated in FIG. 2, the battery post 41 is inserted into the insertion hole 21a. Then, in a state where the battery post 41 is inserted into the insertion hole 21a, the tightened portions 22 are tightened by the bolt 51 and the nut 52 to decrease a diameter of the insertion hole 21a. Thus, the battery terminal portion 20 is mounted in a state where it is electrically connected to the battery post 41.

The connection portion 30 includes a main body portion 31 and a connection terminal portion 32 provided to protrude from the main body portion 31. The connection terminal portion 32 is electrically connected to the battery terminal portion 20. Specifically, the connection terminal portion 32 is electrically connected to the battery terminal portion 20 indirectly through the shunt resistor 200 (see FIG. 4). As described above, in the present embodiment, the wire harness 60 and the battery terminal portion 20 are electrically connected to each other through the connection terminal portion 32. However, the wire harness 60 and the battery terminal portion 20 may be electrically connected to each other in a state where the wire harness 60 is connected to the connection portion 30, and may not be electrically connected to each other through the connection terminal portion 32. For example, in a case where the wire harness 60 and the battery terminal portion 20 are electrically connected to each other and are fastened (fixed) to each other by the connection terminal portion 32 and a nut 72 to be described below, it is possible to interpose an insulating resin between the connection terminal portion 32 and the battery terminal portion 20. As described above, the connection terminal portion 32 may not be electrically connected to the battery terminal portion 20.

In the present embodiment, the connection portion 30 includes a bolt mounting portion 131 of the second bus bar 130, a stud bolt 140 for mounting the wire harness, and a connection side housing 112 holding the stud bolt 140 in a state of electrically connecting the stud bolt 140 to the bolt mounting portion 131 (see FIG. 4). Specifically, the main body portion 31 includes the bolt mounting portion 131, a head portion 141 of the stud bolt 140, and the connection side housing 112. A shaft portion 142 of the stud bolt 140 is the connection terminal portion 32. The connection terminal portion 32 is formed such that a tip thereof faces an upward direction when the battery terminal portion 20 is mounted on the battery post 41.

As illustrated in FIG. 2, a conductive portion 63 of the wire harness 60 is electrically connected to the connection terminal portion 32 of the connection portion 30.

In the present embodiment, the conductive portion 63 is exposed at one end of the wire harness 60. A wire harness terminal 61 is caulked and fixed to the exposed conductive portion 63, such that the conductive portion 63 is electrically connected to the wire harness terminal 61. A load such as an electrical component mounted in the vehicle is connected to the other end of the wire harness 60.

In the present embodiment, the wire harness terminal 61 has a shape in which a tip portion 62 thereof is bent substantially at a right angle. An insertion hole 62a into which the connection terminal portion 32 is inserted is formed in the tip portion 62. As described above, by using the wire harness terminal 61 having the shape in which the tip portion 62 is bent substantially at the right angle, it is possible to allow the wire harness 60 to follow a side surface of the battery 40 at the time of mounting the wire harness terminal 61 on the connection terminal portion 32, such that space saving can be achieved.

In a state where the connection terminal portion 32 is inserted into the insertion hole 62a formed in the tip portion 62, the tip portion 62 is fastened with the nut 72, such that the wire harness terminal 61 is fixed to the connection portion 30, and the wire harness 60 is electrically connected to the connection terminal portion 32.

As described above, the connection terminal portion 32 is electrically connected to the battery terminal portion 20. For this reason, by fixing the wire harness terminal 61 to the connection terminal portion 32 while mounting the battery terminal portion 20 on the battery post 41, a current flows between the load connected to the other end of the wire harness 60 and the battery 40.

In this case, the connection terminal portion 32 is electrically connected to the battery terminal portion 20 through the shunt resistor 200. Therefore, the current flowing between the load and the battery 40 passes through the shunt resistor 200 functioning as the current sensor portion.

By using the current sensor 1 configured as described above, a magnitude of the current flowing between the load and the battery 40 can be detected by the current sensor portion. For this reason, the remaining capacity or the consumption degree of the battery 40 can be determined.

It is noted that the magnitude of the current flowing between the load and the battery 40 can be calculated using a voltage drop generated when a current flows in the shunt resistor 200 and a resistance value of the shunt resistor 200.

In the present embodiment, it is possible to improve reliability of current detection by the current sensor 1.

Specifically, the current sensor 1 includes a housing 100 with a bus bar (see FIG. 4).

The housing 100 with the bus bar includes the first bus bar 120 electrically connected to the battery post 41 and the second bus bar 130 electrically connected to the conductive portion 63 of the wire harness 60. The first bus bar 120 and the second bus bar 130 are held by a housing 110 formed of an insulating resin material to form the housing 100 with the bus bar.

In the present embodiment, the housing 100 with the bus bar is formed by performing insert-molding by an insulating resin material in a state where insert components including the first bus bar 120 and the second bus bar 130 are arranged at predetermined positions. In this case, the insert components are held by the housing 110 in a state where they are partially embedded in the housing 110.

In the present embodiment, the first bus bar 120, the second bus bar 130, the stud bolt 140 for mounting the wire harness, and four connector pins 150 are insert components inserted into the housing 110 at the time of performing the insert-molding.

The first bus bar 120 has conductivity and rigidity, and can be obtained, for example, by bending or pressing a conductive metal plate having a predetermined shape.

The first bus bar 120 includes the battery terminal main body 121 mounted on the battery post 41 and the extending piece 122 provided continuously to the battery terminal main body 121.

The battery terminal main body 121 includes a first facing wall 124 and a second facing wall 125 facing each other and a connecting portion 126 connecting an end portion of the first facing wall 124 and an end portion of the second facing wall 125 to each other and having a substantially U shape. The first facing wall 124 and the second facing wall 125 can be formed, for example, by folding back a portion of a conductive metal plate that becomes the connecting portion 126 in a substantially U shape. Further, in the present embodiment, an insertion hole 124a is formed in a substantially central portion of the first facing wall 124. An insertion hole 125a is formed in a substantially central portion of the second facing wall 125. When viewed along a direction in which the first facing wall 124 and the second facing wall 125 face each other, the insertion hole 124a and the insertion hole 125a overlap each other. When the battery terminal main body 121 is mounted on the battery post 41, the battery post 41 is sequentially inserted into the insertion hole 125a and the insertion hole 124a. As described above, in the present embodiment, the first facing wall 124 and the second facing wall 125 constitute the insertion portion 21 of the battery terminal portion 20 of FIG. 2. The insertion hole 124a and the insertion hole 125a constitute the insertion hole 21a into which the battery post 41 of FIG. 2 is inserted.

In the present embodiment, a wide portion 124b wider than the second facing wall 125 is formed on a side of the first facing wall 124 opposite to the connecting portion 126. Meanwhile, side wall portions 125b and 125b extending toward the first facing wall 124 are formed, respectively, at both ends of the second facing wall 125 in a width direction. Tips of the side wall portions 125b and 125b abut against the wide portion 124b of the first facing wall 124, such that the first facing wall 124 and the second facing wall 125 face each other in a state where the first facing wall 124 and the second facing wall 125 are spaced apart from each other by a predetermined distance (a height of the side wall portion 125b).

In the present embodiment, claw portions 124c and 124c having a shape in which they are bent along the side wall portions 125b and 125b and the second facing wall 125 are provided continuously to both ends of the first facing wall 124 in the width direction. The claw portions 124c and 124c are hooked on the second facing wall 125. According to such a configuration, it is possible to inhibit the second facing wall 125 from being opened with respect to the first facing wall 124.

At a central portion of the battery terminal main body 121 in the width direction, a slit 127 extending from the insertion hole 124a in the first facing wall 124 to the insertion hole 125a in the second facing wall 125 through the connecting portion 126 having substantially the U shape is formed. That is, in the present embodiment, the slit 127 is formed to be in communication with the insertion hole 124a and the insertion hole 125a.

The connecting portion 126 is divided into a first connecting portion 126a and a second connecting portion 126b by the slit 127. By forming the slit 127, inner diameters of the insertion holes 124a and the insertion holes 125a can be increased or decreased. That is, diameters of the insertion holes 124a and the insertion holes 125a are decreased by decreasing a width of the slit 127.

The bolt 51 and the nut 52 for decreasing the width of the slit 127 are arranged in the first connecting portion 126a and the second connecting portion 126b. Specifically, a shaft portion of the bolt 51 is inserted into the first connecting portion 126a and the second connecting portion 126b. The nut 52 is screwed into the shaft portion of the bolt 51. By tightening the nut 52, a distance between the first connecting portion 126a and the second connecting portion 126b (the width of the slit 127) is decreased, such that the diameters of the insertion hole 124a and the insertion hole 125a are decreased. As described above, in the present embodiment, the first connecting portion 126a and the second connecting portion 126b constitute the tightened portion 22.

The extending piece 122 is provided continuously to an end portion of the first facing wall 124 opposite to the connecting portion 126, and includes a flat portion 122b. The flat portion 122b is provided continuously to the first facing wall 124 (wide portion 124b) through a bent portion 122a. The flat portion 122b is arranged in a state where it is offset against the first facing wall 124 in a vertical direction.

The output terminal 123 is formed integrally with the flat portion 122b at an end of the flat portion 122b opposite to the connecting portion 126. The output terminal 123 is connected to the circuit board 300. The output terminal 123 is used to output the potential difference across the shunt resistor 200 to the circuit board 300.

The second bus bar 130 also has conductivity and rigidity, and can be obtained, for example, by bending or pressing a conductive metal plate having a predetermined shape, similar to the first bus bar.

The second bus bar 130 includes the bolt mounting portion 131 on which the stud bolt 140 is mounted, the extending piece 133 arranged in a state in which it is offset against the bolt mounting portion 131 in the vertical direction, and a bent portion 132 connecting the bolt mounting portion 131 and the extending piece 133 to each other.

The bolt mounting portion 131 has a substantially flat plate shape, and an insertion hole 131a into which the shaft portion 142 of the stud bolt 140 is inserted is formed at a substantially central portion of the bolt mounting portion 131. In addition, an extending piece 131b having a shape in which it is bent substantially at a right angle is formed at an end portion of the bolt mounting portion 131. The extending piece 131b is provided in order to increase strength of the housing 110 at a portion embedded with the resin material forming the housing 110.

The extending piece 133 has a substantially flat plate shape. The extending piece 133 includes a facing portion 133a having an end surface facing an end surface of the flat portion 122b, and an extending piece 133b provided continuously to an end portion of the facing portion 133a opposite to the bent portion 132, in a state where the housing 100 with a bus bar is formed. It is noted that a tip of the extending piece 133b is provided in order to increase strength of the housing 110 at a portion embedded with the resin material forming the housing 110.

In the state where the housing 100 with a bus bar is formed, the output terminal 134 is formed integrally with the facing portion 133a at an end portion of the facing portion 133a toward the flat portion 122b. The output terminal 134 is connected to the circuit board 300 together with the output terminal 123, and is used to output the potential difference across the shunt resistor 200 to the circuit board 300.

It is preferable that a surface of the first bus bar 120 and a surface of the second bus bar 130 be plated with tin. According to such a configuration, it becomes easy to perform soldering on the surfaces of the bus bars.

The stud bolt 140 has conductivity and is electrically connected to the wire harness terminal 61 in the present embodiment. That is, the stud bolt 140 is fixed in a state where it is electrically connected to the bolt mounting portion 131 of the second bus bar 130. Specifically, the shaft portion 142 of the stud bolt 140 is inserted into the insertion hole 131a of the bolt mounting portion 131, and the head portion 141 of the stud bolt 140 is in contact with a circumferential portion of the insertion hole 131a in the bolt mounting portion 131. According to such a configuration, the stud bolt 140 is fixed in a state where it is electrically connected to the bolt mounting portion 131.

The wire harness terminal 61 may be electrically connected to the second bus bar 130 when the tip portion 62 is fastened (fixed) using the stud bolt 140 and the nut 72. That is, the wire harness terminal 61 may not be electrically connected to the second bus bar 130 through the stud bolt 140 and the nut 72. For example, an insulating portion such as resin may be interposed between the wire harness terminal 61 and the nut 72 or between the second bus bar 130 and the stud bolt 140.

The connector pin 150 is a member for electrically connecting the circuit board 300 to the mating connector, and has a shape in which a rod-like conductive member is bent. Specifically, the connector pin 150 includes the connector terminal portion 151 conducted and connected to a terminal metal fitting of the mating connector, a circuit board side terminal portion 152 conductive and connected to the circuit board 300, and a connecting portion 153 connecting the connector terminal portion 151 and the circuit board side terminal portion 152 to each other. In the state where the housing 100 with a bus bar is formed, at least a part of the connecting portion 153 is embedded in the housing 110. That is, the connector pin 150 penetrates through the housing 110 to be held by the housing 110.

Such insert components are held by the housing 110 in the state where they are partially embedded in the housing 110, as described above.

The housing 110 includes the main body housing 111 constituting a part of the outer shell of the sensor main body portion 11, the connection side housing 112 constituting a part of the connection portion 30, and the connector housing 113 constituting a part of the connector portion 12, in the present embodiment.

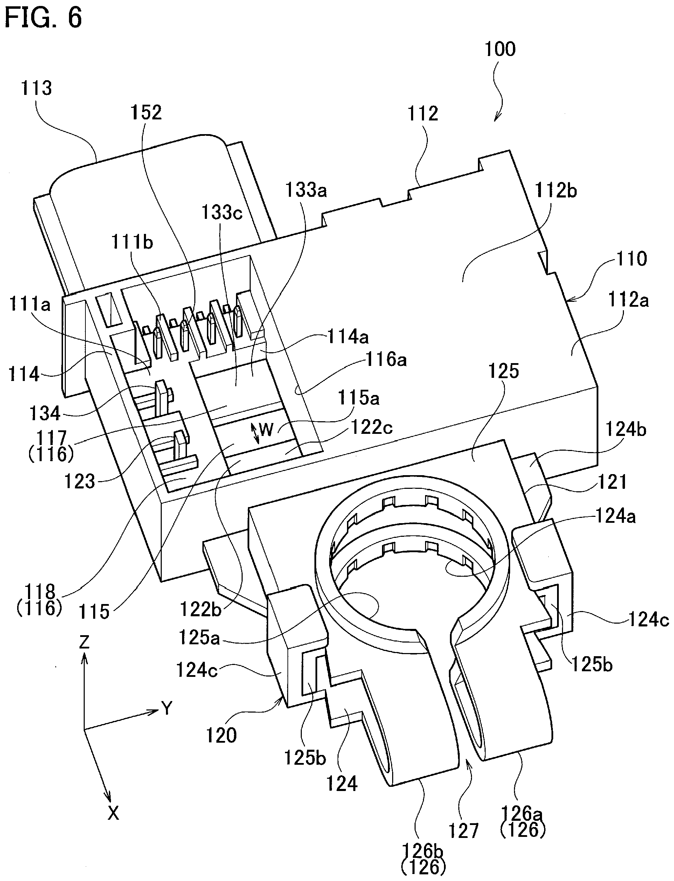

The main body housing 111 is formed to have a recess portion 116 at the center thereof, and has a substantially rectangular box shape. The main body housing 111 includes a deep wall 115 positioned deeper than an opening portion 116a of the recess portion 116 and a circumferential wall 114 continuously provided along entire of an outer circumference of the deep wall 115 (see FIG. 6). The recess portion 116 is defined by an inner surface 114a of the circumferential wall 114 and an inner surface 115a of the deep wall 115.

In the present embodiment, when the deep wall 115 is viewed from the opening portion 116a, a stepped portion 111a having a substantially L shape is formed between the inner surface 115a of the deep wall 115 and the opening portion 116a in the main body housing 111. Such a stepped portion 111a is formed, such that a part of the recess portion 116 becomes a recess portion having a depth greater than that of the other part.

In the state where the housing 100 with a bus bar is formed, a part of the flat portion 122b of the first bus bar 120, a part of the facing portion 133a of the second bus bar 130, tips of the output terminals 123 and 134, and a tip of the circuit board side terminal portion 152 are exposed in the recess portion 116.

Specifically, the main body housing 111 is formed so that a part of the flat portion 122b and a part of the facing portion 133a are exposed in a portion having a deep depth in the recess portion 116. Therefore, in the present embodiment, a part of the flat portion 122b is a first exposed portion 122c exposed in the recess portion 116, and a part of the facing portion 133a is a second exposed portion 133c exposed in the recess portion 116.

The main body housing 111 is formed so that the tips of the output terminals 123 and 134 and the tip of the circuit board side terminal portion 152 protrude from the stepped portion 111a toward the opening portion 116a (exposed in a portion recess having a shallow depth in the recess portion).

Therefore, the shunt resistor 200 is accommodated in the recess portion having the deep depth in the recess portion 116. The circuit board 300 is accommodated in the recess portion having the shallow depth in the recess portion 116.

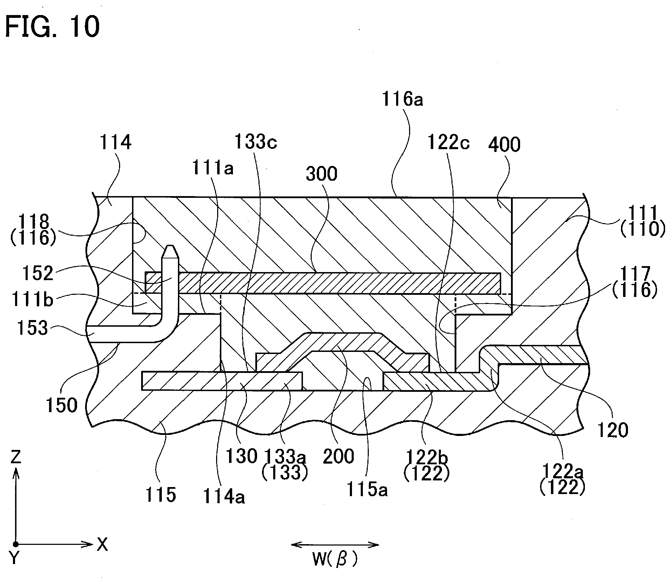

As described above, in the present embodiment, a recess portion defined by the inner surface 115a of the deep wall 115 in the recess portion 116 is a first recess portion 117 accommodating the shunt resistor 200. A recess portion defined by the stepped portion 111a in the recess portion 116 is a second recess portion 118 accommodating the circuit board 300 (see FIG. 10).

In the present embodiment, as illustrated in FIGS. 4 and 10, a plurality of ribs 111b are provided in the recess portion 116. The plurality of ribs 111b are provided to prevent peeling of the sealing portion 400 formed by injecting a sealing material into the recess portion 116 or to improve adhesion by the sealing portion 400. Further, some of the plurality of ribs 111b are formed to project toward the opening portion 116a between the output terminal 123 and the output terminal 134 and between adjacent circuit board terminal portions 152. As illustrated in FIG. 10, when the circuit board 300 is accommodated in the second recess portion 118, the circuit board 300 is placed on the ribs 111b protruding toward the opening portion 116a.

The connection side housing 112 is formed in a substantially rectangular parallelepiped shape, and has a circumferential wall 112a of which one side is provided continuously to a side portion of the main body housing 111. In addition, the connection side housing 112 includes a fixing portion 112b formed inside the circumferential wall 112a and fixing the bolt mounting portion 131 and the stud bolt 140 in a state where the bolt mounting portion 131 and the stud bolt 140 are electrically connected to each other. In the present embodiment, the bolt mounting portion 131 and the head portion 141 of the stud bolt 140 fixed to the bolt mounting portion 131 are embedded in the fixing portion 112b. It is noted that the bolt mounting portion 131 and the stud bolt 140 may be fixed by the fixing portion 112b in a state where they are electrically connected to each other and entire of the bolt mounting portion 131 and entire of the head portion 141 may not be embedded in the fixing portion 112b.

The connector housing 113 is formed in a substantially cylindrical shape, and is provided continuously to the main body housing 111. Specifically, the connector housing 113 is formed to protrude outward from a surface adjacent to a surface of the main body housing 111 to which the connection side housing 112 is provided continuously. As described above, in the present embodiment, the connection side housing 112 and the connector housing 113 protrude from the main body housing 111 so as to extend in directions intersecting with each other.

In the present embodiment, the connector terminal portion 151 of the connector pin 150 is covered by the connector housing 113 in the state where the housing 100 with a bus bar is formed. The connector housing 113 and the connector terminal portion 151 form the connector portion 12 to be fitted to the mating connector.

The housing 100 with a bus bar configured as described above can be formed, for example, as follows.

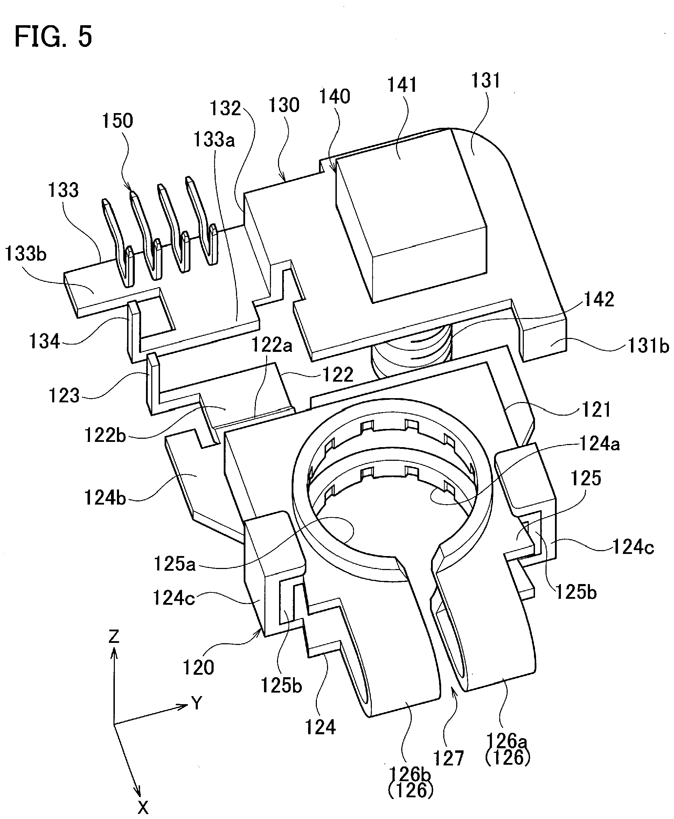

First, the insert components including the first bus bar 120 and the second bus bar 130 are held by a mold (not illustrated) or the like and are arranged in a state illustrated in FIG. 5. That is, the first bus bar 120 and the second bus bar 130 are arranged in a state where the first bus bar 120 and the second bus bar 130 are completely spaced apart from each other. Specifically, the first bus bar 120 and the second bus bar 130 are arranged so that the end surface of the flat portion 122b and the end surface of the facing portion 133a face each other in a state where the end surface of the flat portion 122b and the end surface of the facing portion 133a are spaced apart from each other. In this case, it is preferable that a surface of the flat portion 122b and a surface of the facing portion 133a be substantially coplanar with each other.

In addition, the shaft portion 142 of the stud bolt 140 is inserted into the insertion hole 131a formed in the bolt mounting portion 131 of the second bus bar 130 to bring the head portion 141 into contact with the bolt mounting portion 131. In this case, the shaft portion 142 is inserted into the insertion hole 131a so as to protrude toward an opposite side to the opening portion 116a of the recess portion 116 formed in the main body housing 111.

Then, the four connector pins 150 are arranged above the facing portion 133a (in the opening 116a) in a state where they are spaced apart from the first bus bar 120, the second bus bar 130, and the stud bolt 140. In this case, the four connector pins 150 are arranged such that the connector terminal portions 151 face a lateral direction and the circuit board side terminal portions 152 face an upward direction (direction toward the opening 116a). The respective connector pins 150 are arranged in a state where they are spaced apart from the other connector pins 150.

Then, in a state where the insert components are arranged as illustrated in FIG. 5, insert molding is performed to form the housing 110 in which the insert components are inserted. Specifically, a molten insulating resin material is injected into a cavity formed in a mold (not illustrated) to form the housing 110 in which the insert components are inserted. As the insulating resin material forming the housing 110, for example, a polyphenylene sulfide resin (PPS resin) having a melting point higher than that of solder can be used. In addition, the strength of the housing 110 may be increased by mixing a glass filler or the like with the insulating resin material.

As a result, the housing 100 with a bus bar illustrated in FIG. 6 is formed. It is noted that the first exposed portion 122c and the second exposed portion 133c may be formed by inserting the first bus bar 120 and the second bus bar 130 into the housing 110 in a state in which the first exposed portion 122c and the second exposed portion 133c are connected to each other and then cutting the connection portion between the first exposed portion 122c and the second exposed portion 133c. As a result, flatness of the first exposed portion 122c and the second exposed portion 133c can be increased.

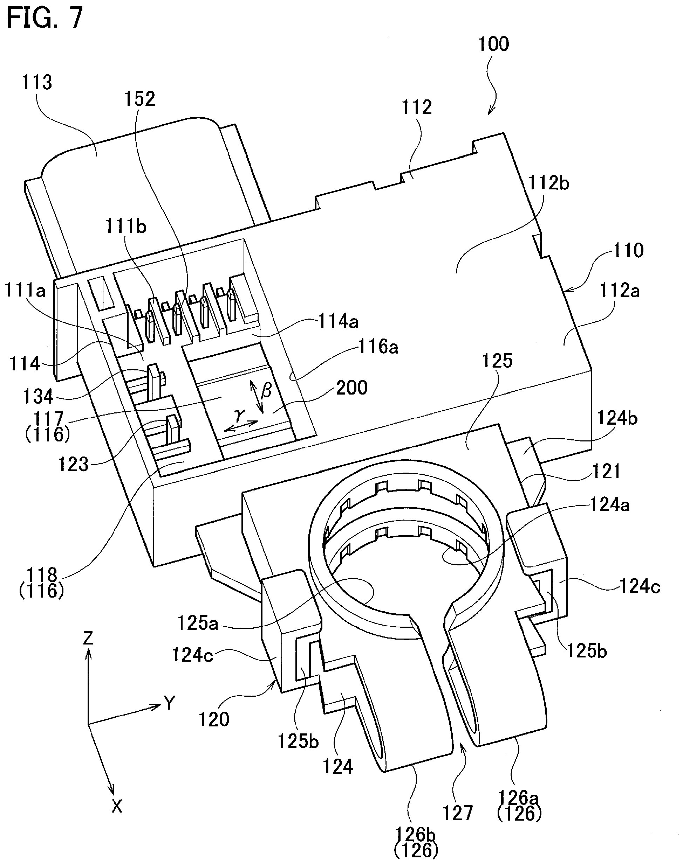

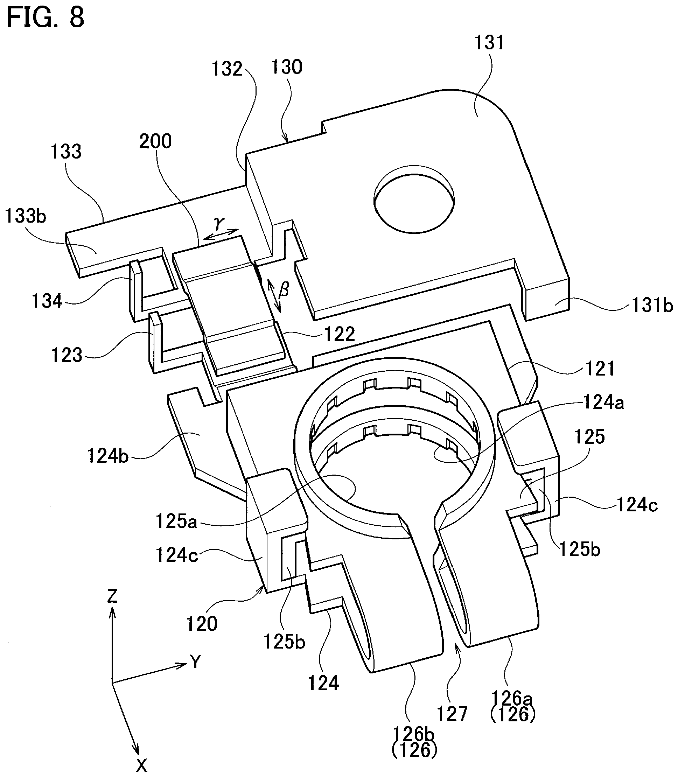

After the housing 100 with a bus bar is formed, the shunt resistor 200 is mounted on the first exposed portion 122c of the first bus bar 120 and the second exposed portion 133c of the second bus bar 130 while being accommodated in the first recess portion 117 (recess portion 116) (See FIG. 7). Therefore, the first bus bar 120 and the second bus bar 130 are inserted into and held by the housing 110 in a state where they are arranged to be spaced apart from each other, and are electrically connected through the shunt resistor 200 (see FIG. 8).

It is noted that the shunt resistor 200 is a resistor of which a change in a resistance value due to a temperature change is relatively small. For this reason, by using the shunt resistor 200, it is possible to obtain the current sensor 1 which is hardly affected by the temperature change.

In the present embodiment, a surface mount type-shunt resistor (chip-like shunt resistor) is used as the shunt resistor 200. As such a shunt resistor 200, a conventionally known shunt resistor can be used.

The shunt resistor 200 is mounted on the first bus bar 120 and the second bus bar 130 by solder. As described above, by mounting the surface mount type shunt resistor 200 using the solder, there is no need to access the shunt resistor 200 from a rear surface at the time of connecting the shunt resistor 200 to the bus bars, such that the shunt resistor 200 can be more easily connected to the bus bars. In addition, since the opening portion (opening portion 116a of the recess portion 116) can be formed in only one side, the injection of the sealing material is facilitated, such that the sealing portion 400 can more easily be formed.

In the present embodiment, the first recess portion 117 in which the shunt resistor 200 is accommodated is formed to be slightly larger than the shunt resistor 200. That is, in a state in which the shunt resistor 200 is accommodated in the first recess portion 117, entire of a circumference of the shunt resistor 200 is surrounded by the inner surface 114a defining the first recess portion 117. Therefore, when the shunt resistor 200 is soldered to the first exposed portion 122c and the second exposed portion 133c, the solder is blocked by the inner surface 114a, such that the soldering can be more reliably performed. In addition, since displacement of the shunt resistor 200 is suppressed by the inner surface 114a, an error due to connection displacement of the shunt resistor 200 can be decreased.

After the shunt resistor 200 is mounted on the first exposed portion 122c and the second exposed portion 133c, the circuit board 300 is accommodated in the second recess portion 118 (recess portion 116).

The circuit board 300 has a substantially rectangular shape, and an amplifier circuit or the like that amplifies a voltage (potential difference) of the shunt resistor 200 input to the circuit board 300 is formed by mounting various electronic components on the circuit board 300. It is noted that illustration of the electronic components mounted on the circuit board 300 is omitted. In addition, insertion holes 310 into which the tips of the respective circuit board side terminal portions 152 are inserted, and insertion holes 320 and 320 into which the tips of the output terminals 123 and 134 are inserted are formed in the circuit board 300.

Therefore, the circuit board 300 is placed on the ribs 111b in a state where the tips of the respective circuit board side terminal portion 152 are inserted into the insertion hole 310 and the tips of the output terminals 123 and 134 are inserted into the insertion holes 320 and 320, respectively, such that the circuit board 300 is accommodated in the second recess portion 118.. In this case, it is preferable that entire of the shunt resistor 200 be covered by the circuit board 300 (the entire of the shunt resistor 200 overlaps the circuit board 300 in the vertical direction). Therefore, the shunt resistor 200 and the circuit board 300 can be accommodated in the recess portion 116 without enlarging the recess portion 116.

Then, in a state where the circuit board 300 is accommodated in the second recess portion 118, the circuit board side terminal portions 152 and the output terminals 123 and 134 are soldered to (mounted on) the circuit board 300.

The mounting of the shunt resistor 200 and the mounting of the circuit board 300 (the soldering of the circuit board side terminal portions 152 and the output terminals 123 and 134 to the circuit board 300) are performed at one time by, for example, reflow soldering. In this case, the mounting of the electronic components on the circuit board 300 can be simultaneously performed.

Then, a sealing material softer than the resin material forming the housing 110 is filled in the recess portion 116 to form the sealing portion 400. As such a sealing material, for example, a urethane resin having elasticity and adhesiveness can be used. An interface is adhered by sealing the recess portion 116 in which the shunt resistor 200 and the circuit board 300 are accommodated by a sealing material, such that waterproof and dustproof effects can be improved and generation of static electricity can be suppressed.

In the present embodiment, when the current sensor 1 is mounted on the battery post 41, the recess portion 116 is formed so that the opening portion 116a is opened downward. For this reason, when the current sensor 1 is mounted on the battery post 41, a surface of the sealing portion 400 faces a downward direction. For this reason, even though water infiltrates into the recess portion 116, the water can be drained without being accumulated in the recess portion 116.

By forming the sealing portion 400, the current sensor 1 according to the present embodiment is formed. It is noted that a method of manufacturing the current sensor 1 described above is an example, and it is also possible to manufacture the current sensor 1 by another method.

As described above, the current sensor 1 according to the present embodiment includes the housing 100 with a bus bar. The housing 100 with a bus bar has the housing 110 formed of the insulating resin material, and the first bus bar 120 inserted into the housing 110 so as to be partially embedded in the housing 110. The housing 100 with a bus bar has the second bus bar 130 arranged in a state of being spaced apart from the first bus bar 120 and inserted into the housing 110 so as to be partially embedded in the housing 110.

The current sensor 1 includes the shunt resistor 200 electrically connecting the first bus bar 120 and the second bus bar 130 to each other.

The recess portion 116 in which the first exposed portion 122c of the first bus bar 120 is exposed and the second exposed portion 133c of the second bus bar 130 is exposed is formed in the housing 110.

The shunt resistor 200 electrically connects the first exposed portion 122c and the second exposed portion 133c to each other in a state where it is accommodated in the recess portion 116.

According to such a configuration, it is possible to connect the shunt resistor 200 to the first bus bar 120 and the second bus bar 130 after the housing 100 with a bus bar is formed by the insert molding. Therefore, as in a case of insert-molding the bus bars with the shunt resistor, a pressure of the resin material is not applied to bonded portions between the shunt resistor 200 and the bus bars (the first bus bar 120 and the second bus bar 130).

As a result, it is possible to inhibit the shunt resistor 200 or the bonded portions between the shunt resistor 200 and the bus bars from being deformed, and it is possible to inhibit the shunt resistor 200 and the bus bars from being electrically disconnected from each other. That is, the shunt resistor 200 and the bus bars can more certainly be electrically connected to each other.

The shunt resistor 200 is accommodated in a recess portion 116 formed in the housing 110. For this reason, it is possible to inhibit a force generated in the housing 110 due to thermal expansion and contraction of the housing 110, vibration of the current sensor 1, or the like from being directly transferred to the shunt resistor 200 and the bonded portions between the shunt resistor 200 and the bus bars. As a result the shunt resistor 200 and the bus bars can more certainly be electrically connected to each other. In addition, since it is possible to prevent the insert molding from being performed in a state where shunt resistor 200 is connected to the first bus bar 120 and the second bus bar 130, it is possible to prevent a molding pressure or a stress of thermal expansion and contraction applied at the time of performing the insert molding from being applied to the shunt resistor 200.

It is possible to suppress occurrence of friction between the housing 110 and the shunt resistor 200 at the time of thermal expansion and contraction of the housing 110, at the time of vibration of the current sensor 1 or the like. As a result, generation of static electricity can be suppressed to decrease noise of the current sensor 1. For example, in a case where a resin having elasticity and adhesiveness is used as the sealing material for forming the sealing portion 400, the sealing portion 400 is closely adhered to the shunt resistor 200 in a state of having elasticity. For this reason, the sealing portion 400 moves together with the shunt resistor 200 at the time of the thermal expansion and contraction, the vibration of the current sensor 1 or the like. As described above, the sealing portion 400 moves together with the shunt resistor 200, such that it is possible to suppress occurrence of friction, and it is thus possible to suppress generation of static electricity due to the friction.

As described above, according to the present embodiment, it is possible to obtain the current sensor 1 capable of further improving reliability of current detection.

By forming the housing 100 with a bus bar by the insert molding and then connecting the shunt resistor 200 to the first bus bar 120 and the second bus bar 130, it is possible to suppress deterioration of the shunt resistor 200 due to the insert molding. Further, by insert-molding the housing 100 with a bus bar and then mounting the shunt resistor 200, it is possible to form a mounted shape of the shunt resistor 200 in advance in the housing 110, such that it is possible to more easily mount the shunt resistor 200.

In the present embodiment, the current sensor 1 further includes the circuit board 300 to which the potential difference across the shunt resistor 200 is input. The circuit board 300 is arranged in the recess portion 116.

According to such a configuration, a recess portion accommodating the shunt resistor 200 and a recess portion accommodating the circuit board 300 need not to be separately formed in the housing 110, such that a configuration can be simplified.

In the present embodiment, the current sensor 1 further includes a pair of output terminals 123 and 134 connected to the circuit board 300 and outputting the potential difference across the shunt resistor 200 to the circuit board 300.

One output terminal 123 of the pair of output terminals 123 and 134 is formed integrally with the first bus bar 120, and the other output terminal 134 of the pair of output terminals 123 and 134 is formed integrally with the second bus bar 130.

As described above, by forming the output terminals 123 and 134 directly in the bus bars (the first bus bar 120 and the second bus bar 130), it is possible to transmit more accurate voltage data.

In the present embodiment, the shunt resistor 200 is soldered directly to the bus bars (the first bus bar 120 and the second bus bar 130). For this reason, cost reduction can be achieved as compared with a case where the shunt resistor 200 is mounted on the circuit board 300, such that it is possible to cope with a large current.

In the present embodiment, the sealing portion 400 sealed with the sealing material softer than the resin material is provided in the recess portion 116.

According to such a configuration, the waterproof and dustproof effects can be improved, and the generation of the static electricity can be suppressed.

Incidentally, when the housing 110 thermally expands and contracts due to a temperature change, the first bus bar 120 and the second bus bar 130 held by the housing 110 move. By this movement, an interval between the first exposed portion 122c of the first bus bar 120 and the second exposed portion 133c of the second bus bar 130 is changed depending on a thermal expansion coefficient of the insulating resin material that is a material of the housing 110.

Meanwhile, when a temperature change occurs in the shunt resistor 200 of which both ends are soldered to the first exposed portion 122c and the second exposed portion 133c, respectively, thermal expansion and contraction depending on a thermal expansion coefficient of a metal material used for the shunt resistor 200 is generated in the shunt resistor 200.

Here, thermal expansion coefficients of the resin material of the housing 110 and the metal material of the shunt resistor 200 are different from each other. For this reason, the housing 110 and the shunt resistor 200 thermally expand and contract at different thermal expansion coefficients in an interval direction between the first exposed portion 122c of the first bus bar 120 and the second exposed portion 133c of the second bus bar 130 at the time of temperature change.

Therefore, a stress in the interval direction is generated between the first exposed portion 122c and the second exposed portion 133c depending on a difference in the thermal expansion coefficient between the housing 110 and the shunt resistor 200 at soldered places between the first and second exposed portions 122c and 133c and the shunt resistor 200.

Incidentally, in a case where the glass filler or the like is mixed with the resin material of the housing 110, the thermal expansion coefficient of the housing 110 is relatively low in a fiber direction of the glass filler mixed with the resin material, and is relatively high in the other directions. Therefore, the difference in the thermal expansion coefficient between the housing 110 and the shunt resistor 200 is relatively small in the fiber direction of the glass filler in the resin material and is relatively large in the other directions.

For this reason, when the fiber direction of the glass filler in the resin material is aligned with the interval direction between the first exposed portion 122c and the second exposed portion 133c, the difference in the thermal expansion coefficient between the housing 110 and the shunt resistor 200 in this interval direction becomes small. In this case, the stress in the interval direction between the first exposed portion 122c and the second exposed portion 133c generated at the soldered places of the shunt resistor 200 is decreased. Incidentally, the fiber direction of the glass filler is a direction along a flow direction of the resin material in the mold (not illustrated) when the housing 100 with a bus bar is formed by the insert molding.

The thermal expansion coefficient of the housing 110 formed by the insert molding may be relatively small in the flow direction of the resin material at the time of insert molding and may be relatively large in the other directions, even though the resin material does not contain the glass filler.

Therefore, in the present embodiment, the flow direction of the resin material of the housing 110 is devised at the time of insert molding of the housing 100 with a bus bar. The flow direction of the resin material at the time of insert molding will be described below.

First, as illustrated in FIG. 6, the first exposed portion 122c of the first bus bar 120 and the second exposed portion 133c of the second bus bar 130 are exposed in the recess portion 116 of the housing 110, and are arranged along the inner surface 115a of the deep wall 115. The deep wall 115 of the recess portion 116 is in a positional relationship of back and front with the sensor main body portion 11 of FIG. 2 provided on a surface of the housing 110.

As described at the beginning of the present embodiment, the heat radiating portion 11a having the corrugated shape is exposed on the surface of the sensor main body portion 11 of FIG. 2. The corrugated shape of the heat radiating portion 11a can be configured by arranging the metal plate having the corrugated shape on a portion exposed on the surface of the sensor main body portion 11 or can be configured by allowing a shape of the main body housing 111 itself of the portion to be the corrugated shape.

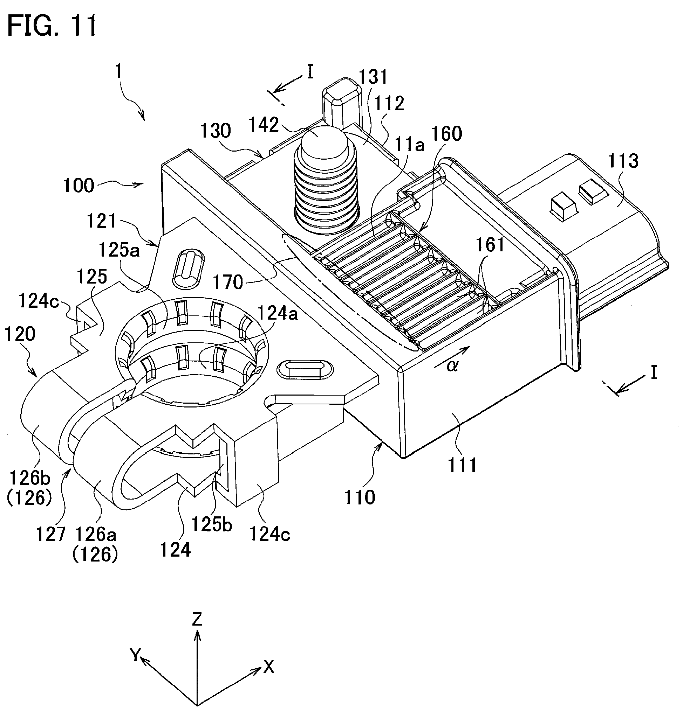

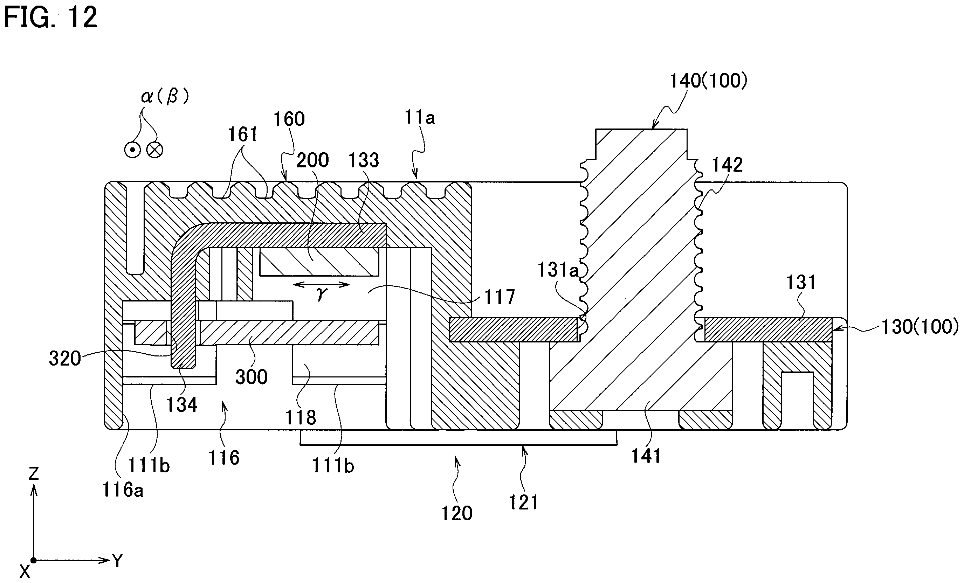

In either case, when the housing 100 with a bus bar is formed by the insert molding, a rugged portion 160 corresponding to the corrugated shape of the heat radiating portion 11a needs to be formed at the portion of the surface of the housing 110 exposed to the surface of the sensor main body portion 11, as illustrated in FIGS. 11 and 12.

FIG. 11 is a perspective view of the current sensor 1 illustrating the rugged portion 160 formed in the heat radiating portion 11a of the housing 110 exposed on the surface of the sensor main body portion 11, and FIG. 12 is a cross-sectional view taken along line I-I of FIG. 11.

As illustrated in FIG. 11, the rugged portion 160 has a plurality of linear grooves 161. The respective grooves 161 extend along the longitudinal direction X of the current sensor 1, and are arranged side by side at equal intervals in the width direction Y of the current sensor 1 (direction orthogonal to the interval direction W). In the present embodiment, the respective grooves 161 extend in the longitudinal direction X of the current sensor 1, and are aligned in the same direction as the interval direction W between the first exposed portion 122c and the second exposed portion 133c exposed in the recess portion 116 of the housing 110 illustrated in FIG. 6.

For this reason, a plurality of projecting pieces (not illustrated) having a cross section of a shape obtained by inverting a cross-sectional shape of each groove 161 illustrated in FIG. 12 are formed side by side, in a portion forming the rugged portion 160 on the surface of the housing 110 in the mold (not illustrated) used for insert-molding the housing 100 with a bus bar. Therefore, as illustrated in FIG. 11, a flow direction α when the resin material of the housing 110 filled in a cavity (not illustrated) of the mold flows in the portion forming the rugged portion 160 is regulated to be the longitudinal direction X of the current sensor 1 in which each groove 161 extends.

In addition, a gate arrangement area 170 surrounded by an alternate long and short dash line in FIG. 11 refers to a range of a position of a filling gate of the resin material provided in the mold. Even though the position of the filling gate of the mold is offset with respect to the rugged portion 160 in the width direction Y of the current sensor 1 within a range of the gate arrangement area 170, the flow direction α of the resin material in the portion forming the rugged portion 160 remains unchanged in the longitudinal direction X of the current sensor 1.

In addition, the resin material flowing in a portion forming the main body housing 111 around the rugged portion 160 is also induced to the resin material flowing in the portion forming the rugged portion 160 with being regulated in the grooves 161 to flow in the longitudinal direction X of the current sensor 1. For this reason, the main body housing 111 of the housing 110 having the recess portion 116 in which the first exposed portion 122c of the first bus bar 120 and the second exposed portion 133c of the second bus bar 130 are exposed is formed by the resin material flowing in the flow direction α along the longitudinal direction X of the current sensor 1.

Here, a relationship between the flow direction α of the resin material forming the recess portion 116 of the main body housing 111 in the mold and the interval direction W (see FIG. 6) between the first exposed portion 122c of the first bus bar 120 and the second exposed portion 133c of the second bus bar 130 to which the shunt resistor 200 is connected will be described.

A thermal expansion coefficient of the recess portion 116 of the main body housing 111 formed by flowing the resin material in the mold is relatively low in the flow direction α of the resin material, and is relatively high in a direction orthogonal to the flow direction α. Therefore, a difference in the thermal expansion coefficient between the recess portion 116 of the main body housing 111 and the shunt resistor 200 is relatively small in the flow direction α of the resin material and is relatively large in the direction orthogonal to the flow direction α.

Therefore, in the present embodiment, the flow direction α of the resin material in the portion forming the main body housing 111 having the recess portion 116 is aligned with the interval direction W between the first exposed portion 122c and the second exposed portion 133c exposed in the recess portion 116 (see FIG. 6). This interval direction W is the same as the longitudinal direction of the current sensor 1 in which the grooves 161 extend.

When the main body housing 111 having the recess portion 116 is formed of the resin material flowing along the flow direction α aligned with the interval direction W between the first exposed portion 122c and the second exposed portion 133c, the difference in the thermal expansion coefficient between the main body housing 111 and the shunt resistor 200 is smallest in the interval direction W described above.

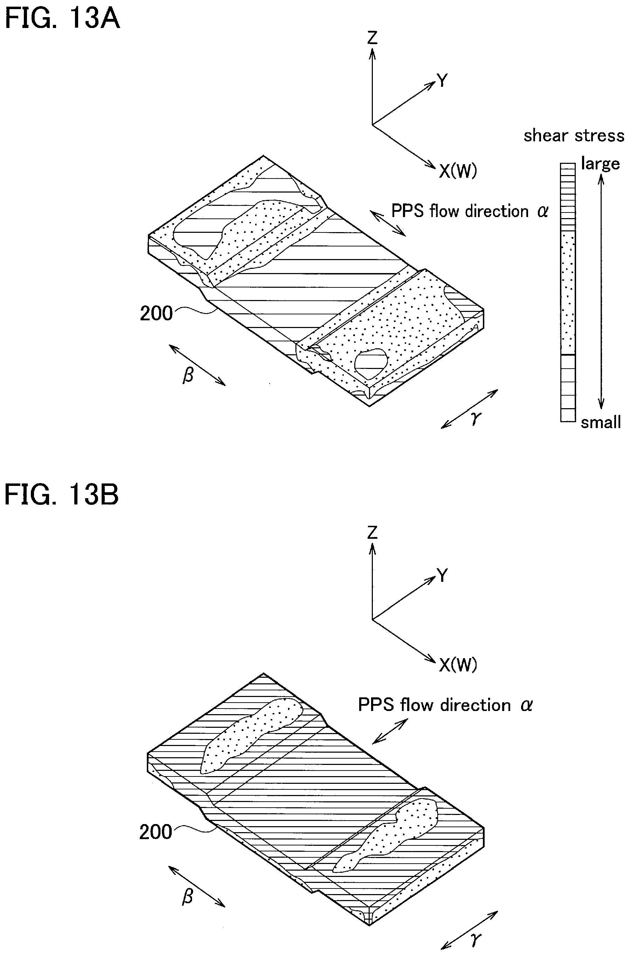

Therefore, all stresses in the interval direction W (shear stresses) generated at each of places of the shunt resistor 200 soldered to the first exposed portion 122c and the second exposed portion 133c due to the difference in the thermal expansion coefficient at the time of temperature change become small to medium values as illustrated in a distribution diagram of FIG. 13A.

For comparison, a case where the flow direction α of the resin material in the portion forming the main body housing 111 having the recess portion 116 is aligned with the width direction Y of the current sensor 1 orthogonal to the longitudinal direction X of the current sensor 1 in which the grooves 161 extend is considered.

When the main body housing 111 having the recess portion 116 is formed of the resin material flowing along the flow direction α aligned with the width direction Y of the current sensor 1, the difference in the thermal expansion coefficient between the main body housing 111 and the shunt resistor 200 is smallest in the width direction Y of the current sensor 1. In other words, the difference in the thermal expansion coefficient between the main body housing 111 and the shunt resistor 200 is largest in the interval direction W between the first exposed portion 122c and the second exposed portion 133c.

Therefore, in a case where the main body housing 111 and the shunt resistor 200 thermally expand and contract due to the temperature change, a large difference is generated in a thermal expansion and contraction amount between the main body housing 111 and the shunt resistor 200 in the interval direction W between the first exposed portion 122c and the second exposed portion 133c.

In this case, stresses in the interval direction W (shear stresses) generated at each of the places of the shunt resistor 200 soldered to the first exposed portion 122c and the second exposed portion 133c due to the difference in the thermal expansion and contraction amount between the main body housing 111 and the shunt resistor 200 become large values as illustrated in a distribution diagram of FIG. 13B. When the stresses (shear stresses) generated at the soldered places of the shunt resistor 200 are large, deformation or the like occurs in the shunt resistor 200, such that accuracy of current detection using the shunt resistor 200 is decreased, and thus, reliability of the current detection cannot be maintained.

On the other hand, in the present embodiment, the flow direction α of the resin material is aligned with the interval direction W between the first exposed portion 122c and the second exposed portion 133c, such that a large difference is not generated in the thermal expansion and contraction amount between the main body housing 111 and the shunt resistor 200 in the interval direction W due to the temperature change.

For this reason, the stresses (shear stresses) in the interval direction W generated at the soldered places of the shunt resistor 200 are suppressed to be small as illustrated in FIG. 13A to suppress the decrease in the accuracy of the current detection due to the deformation of the shunt resistor 200, such that it is possible to further improve the reliability of the current detection.

As illustrated in FIGS. 4 to 7, in the current sensor 1 according to the present embodiment, the shunt resistor 200 and the first and second exposed portions 122c and 133c are soldered to each other at both ends of the shunt resistor 200 in a longitudinal direction β of the shunt resistor 200. For this reason, the stresses generated at the soldering portions when the shunt resistor 200 thermally expands and contracts due to the temperature change, become larger as compared with a case where both ends of the shunt resistor 200 in a width direction γ of the shunt resistor 200 orthogonal to the longitudinal direction β of the shunt resistor 200 and the first and second exposed portions 122c and 133c are soldered to each other.

Therefore, in the present embodiment, the resin material of the portion forming the main body housing 111 is made to flow in the interval direction W between the first exposed portion 122c and the second exposed portion 133c to make the thermal expansion coefficient of the main body housing 111 closest to the thermal expansion coefficient of the shunt resistor 200 in the interval direction W. As a result, even though the shunt resistor 200 and the first and second exposed portions 122c and 133c are soldered to each other at both ends of the shunt resistor 200 in the longitudinal direction β of the shunt resistor 200, a configuration in which magnitudes of the stresses generated at the soldered places are suppressed to be as small as possible can be realized.

Although a preferred embodiment of the present invention has been described hereinabove, the present invention is not limited to the embodiment described above, and can be variously modified.

For example, a case where the output terminal 123 is formed integrally with the first bus bar 120 and the output terminal 134 is formed integrally with the second bus bar 130 has been described by way of example in the embodiment described above, but an output terminal may be formed as a separate component from the first bus bar or the second bus bar.

In addition, specifications (shape, size, layout, and the like) of the housing or the first and second bus bars and other details can be appropriately changed.

## Claims

1. A current sensor comprising:
a housing with a bus bar that includes a housing formed of an insulating resin material, a first bus bar inserted into the housing so as to be partially embedded in the housing and mounted on a battery post, and a second bus bar inserted into the housing so as to be partially embedded in the housing in a state where the second bus bar is spaced apart from the first bus bar and connected to a wire harness; and
a shunt resistor that electrically connects the first bus bar and the second bus bar to each other,
wherein a recess portion in which a first exposed portion of the first bus bar is exposed and a second exposed portion of the second bus bar is exposed, is formed in the housing, and
the shunt resistor electrically connects the first exposed portion and the second exposed portion to each other in a state where the shunt resistor is accommodated in the recess portion.

2. The current sensor according to claim 1, further comprising
a circuit board to which a potential difference across the shunt resistor is input,
wherein the circuit board is arranged in the recess portion.

3. The current sensor according to claim 2, further comprising
a pair of output terminals that are connected to the circuit board and output the potential difference across the shunt resistor to the circuit board,
wherein one output terminal of the pair of output terminals is formed integrally with the first bus bar, and the other output terminal of the pair of output terminals is formed integrally with the second bus bar.

4. The current sensor according to any one of clams 1 to 3, wherein a sealing portion sealed by a sealing material softer than the resin material is provided in the recess portion.

5. The current sensor according to any one of clams 1 to 4,
wherein a rugged portion is formed on a surface portion corresponding to the recess portion in a surface exposed to the outside of the housing, and
the rugged portion is configured by arranging a plurality of grooves at predetermined intervals in a direction orthogonal to an interval direction between the first exposed portion and the second exposed portion in the recess portion, the grooves extending in the interval direction.

6. The current sensor according to claim 5, wherein the shunt resistor is formed to have a larger dimension in the interval direction than in a direction orthogonal to the interval direction.
